(19)

**Europäisches Patentamt**

**European Patent Office**

**Office européen des brevets**

(11) **EP 4 105 609 B1**

(12) **EUROPÄISCHE PATENTSCHRIFT**

(45) Veröffentlichungstag und Bekanntmachung des Hinweises auf die Patenterteilung:
**31.01.2024 Patentblatt 2024/05**

(21) Anmeldenummer: **22178793.0**

(22) Anmeldetag: **14.06.2022**

(51) Internationale Patentklassifikation (IPC):
***G01D 5/20*** (2006.01)

(52) Gemeinsame Patentklassifikation (CPC):
**G01D 5/2073**

(54) **POSITIONSERFASSUNG MIT EINEM INDUKTIVEN POSITIONSSENSOR**

POSITION DETECTION USING AN INDUCTIVE POSITION SENSOR

DÉTECTION DE LA POSITION À L'AIDE D'UN CAPTEUR INDUCTIF DE POSITION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.06.2021 AT 504842021**

(43) Veröffentlichungstag der Anmeldung:
**21.12.2022 Patentblatt 2022/51**

(73) Patentinhaber: **B&R Industrial Automation GmbH 5142 Eggelsberg (AT)**

(72) Erfinder:
• **Höller, Florian 5142 Eggelsberg (AT)**
• **Reichhartinger, Roland 5142 Eggelsberg (AT)**

(74) Vertreter: **Patentanwälte Pinter & Weiss OG Prinz-Eugen-Straße 70 1040 Wien (AT)**

(56) Entgegenhaltungen:
EP-A1- 1 158 276        EP-A2- 2 533 019
DE-A1-102007 011 064     DE-T2-602004 005 672

• **Szymczak ET AL: "Präzisions-Resolver/Digital-Wandler misst Winkelposition und Drehzahl", all-electronics, 28. Mai 2014 (2014-05-28), Seiten 1-13, XP055958402, Gefunden im Internet: URL:https://www.all-electronics.de/elektronik-entwicklung/praezisions-resolverdigital-wandler-misst-winkelposition-und-drehzahl-350.html [gefunden am 2022-09-07]**

## Beschreibung

Die gegenständliche Erfindung betrifft ein Verfahren zur Bestimmung der Position eines bewegten Teils relativ zu einem ortsfesten Teil mittels eines induktiven Positionssensors, wobei am bewegten Teil eine Erregerwicklung angeordnet ist und am ortsfesten Teil zumindest eine Sekundärwicklung, oder umgekehrt, und in die Erregerwicklung ein Erregersignal mit einer Erregerfrequenz und einer Erregeramplitude eingespeist wird, das ein elektromagnetisches Erregerfeld erzeugt, das in der Sekundärwicklung ein Messsignal induziert, das erfasst wird, und dem Messsignal ein Rauschsignal überlagert ist. Die Erfindung betrifft auch eine Auswerteeinheit für einen induktiven Positionssensor mit einem solchen Verfahren zur Bestimmung der Position.

Ein Resolver ist ein rotatorischer Lagegeber, der induktiv arbeitet und robust und kostengünstig ist, weshalb ein Resolver vielfältig eingesetzt wird. Ein Resolver ermöglicht die Erfassung der Winkellage eines Rotors des Resolvers. Wird der Rotor des Resolvers mit einer Welle einer Maschine verbunden, dann kann damit die Winkellage der Welle erfasst werden. Ein Beispiel einer typischen Anwendung eines Resolvers ist bei einem Elektromotor, um eine Lageinformation der Motorwelle zu erhalten. Die Kombination aus Elektromotor und Resolver wird oftmals auch als Servomotor bezeichnet. Die Lageinformation kann dann zur Regelung, beispielsweise einer Positionsregelung oder Geschwindigkeitsregelung, eines Servoantriebs bestehend aus dem Servomotor und einer damit angetriebenen Last verwendet werden.

In einem Resolver gibt es eine Erregerwicklung, die mit dem Rotor des Resolvers rotiert und zumindest zwei, bezogen auf die Erregerwicklung feststehende Sekundärwicklungen. Die Erregerwicklung wird mit einem hochfrequenten Erregersignal, typischerweise im Frequenzbereich von 1kHz bis 10kHz, beaufschlagt. Die in den Sekundärwicklungen gemessenen, aufgrund des rotierenden Magnetfeldes der Erregerwicklung induzierten Spannungen pulsieren mit der gleichen Frequenz wie das Erregersignal, ihre Amplituden sind jedoch von der Stellung der Erregerwicklung zur jeweiligen Sekundärwicklung abhängig. Diese Spannungen werden als Messsignale vom Resolver ausgegeben und werden in einer nachgelagerten Auswerteeinheit ausgewertet, um daraus die Winkellage zu ermitteln. Es handelt sich damit um eine Amplitudenmodulation des Messsignals. Die Sekundärwicklungen sind üblicherweise 90° versetzt zueinander angeordnet, sodass die gemessenen Spannungen 90° phasenverschoben sind. Es sind aber natürlich auch andere Winkel möglich. Die Amplituden der gemessenen Spannungen verlaufen damit als Sinusfunktion in Abhängigkeit von der Lage der Erregerwicklung zur Sekundärwicklung, bzw. als Cosinusfunktion bei der um 90° versetzt angeordneten Sekundärwicklung, oder allgemein als Sinusfunktion mit einem bestimmten Phasenversatz. Die Auswertung beider Messsignale, beispielsweise mittels der Arkustangensfunktion (üblicherweise arctan2-Funktion), ermöglicht eine eindeutige Berechnung der aktuellen Winkellage des Rotors des Resolvers.

Die eigentliche Lageinformation liegt somit in der Hüllkurve des Messsignale, die aus den Messsignalen extrahiert wird. Die Hüllkurve entspricht der Sinusfunktion (bzw. Cosinusfunktion) der gemessenen Spannung, wobei die Periodendauer einer Umdrehung des Rotors entspricht und die Periodendauer damit von der Winkelgeschwindigkeit des Rotors abhängig ist. Eine gängige Vorgehensweise zur Auswertung ist, die Messsignale von einer Auswerteelektronik mit einem Analog-Digital-Wandler immer genau dann abzutasten, wenn das Erregersignal sein Maximum erreicht. Da das Erregersignal üblicherweise ebenso in der Auswerteelektronik gebildet wird, sind die erforderlichen Abtastzeitpunkte exakt bekannt, oder können alternativ auch einfach ermittelt werden. Die Auswertelektronik erfasst damit lediglich die Scheitelwerte der Messsignale und eliminiert auf diese Weise das höherfrequente Erregersignal. Übrig bleiben sinusbzw. cosinusförmige Signalverläufe mit einer Periodendauer, die einer Umdrehung des Rotors entspricht, die die eigentliche Lageinformation enthalten und die ausgewertet werden, beispielsweise mittel Arkustangens.

Das Erregersignal des Resolvers, insbesondere dessen Amplitude und Frequenz, wird in der Regel vorab festgelegt, beispielsweise aufgrund des Datenblattes des Resolvers. Das Erregersignal wird im Betrieb des Resolvers, nach Einstellung, üblicherweise nicht geändert.

In realen Implementierungen kommt es aber immerzu einem Rauschen am vom Resolver ausgegebenen Messsignal, beispielsweise durch stochastisches Bauteilrauschen oder systematisches Rauschen. Das stochastische Rauschen ist in er Regel durch thermisches Rauschen und Schrotrauschen der Bauteile in der Auswerteelektronik bedingt und kann als weißes Rauschen modelliert werden. Das systematische Rauschen kann sich aus der Anwendung des Resolvers ergeben. Bei Servoantrieben werden oftmals Umrichter oder Wechselrichter verwendet, in denen Halbleiterschalter hochfrequent geschaltet werden. Das kann zu hochfrequenten Einkopplungen auf das Messsignal führen. Auch ein induktives Übersprechen der Motorströme in einem Servoantrieb oder anderer elektrischer Ströme im Umfeld des Resolvers sind denkbar. Solche Störquellen können die Präzision der aus dem Resolver erhältlichen Lageinformation erheblich einschränken. Unter Präzision wird dabei auch die erreichbare zeitliche Auflösung der erhaltenen Lageinformation verstanden. Darunter wird insbesondere verstanden, dass in einer Umdrehung des Rotors des Resolvers die Lageinformation aufgrund von Störungen des Messsignals möglicherweise nicht mit der gewünschten zeitlichen Auflösung erhalten werden kann, weil zu bestimmten Zeitpunkten, aufgrund des Rauschens keine Lageinformation ermittelt werden kann.

Mit einer eingeschränkten Präzision der Lageinformation ergeben sich dann Folgeprobleme. In einem Servoantrieb wird die Lageinformation beispielsweise verwendet, um den Servoantrieb zu regeln. Die Lageinformation wird hierfür als Istwert der Regelung verwendet. Je unpräziser der Istwert, umso robuster muss die Regelung ausgeführt sein, was aber üblicherweise mit einer reduzierten Dynamik der Regelung einhergeht. Damit kann der Servoantrieb dynamischen Sollwerten (im Sinne von zeitlichen Sollwertverläufen mit großen zeitlichen Änderungsraten, also große Änderungen des Sollwertes in kurzen Zeitabständen) schlechter oder langsamer folgen. Das Regelverhalten des Servoantriebs wird damit schlechter und die Dynamik der Regelung ist eingeschränkt.

Das Nutzsignal im Messignal, die amplitudenmodulierte Sinusschwingung, ist wie erläutert unvermeidbar in einem Rauschsignal eingebettet. Um die Lageinformation zu erhalten, muss das Nutzsignal aus dem Messignal extrahierbar sein. Dazu ist es notwendig, dass sich das Nutzsignal deutlich vom Hintergrundrauschen (Rauschsignal) abhebt. In diesem Zusammenhang wurde das Signal-Rausch-Verhältnis (auch Signal-Rausch-Abstand), abgekürzt auch als SNR bezeichnet, eingeführt. Der SNR ist ein Maß für die Qualität eines Nutzsignals, das in einem Rauschsignal eingebettet ist. Der SNR ist allgemein definiert als das Verhältnis der mittleren Leistung des Nutzsignals zur mittleren Rauschleistung des Rauschsignals. Je größer der SNR, umso besser kann das Nutzsignal aus dem verrauschten Messignal extrahiert werden. Wird der SNR zu klein, kann das Nutzsignal nicht mehr oder nur mehr unzureichend oder mit geringerer zeitlicher Auflösung extrahiert werden.

Um einen ausreichend großen SNR sicherzustellen, wurde bisher die Amplitude des Erregersignal ausreichend groß gewählt. Man will die Amplitude aber natürlich auch nicht zu groß wählen, da das zu thermischen Problemen im Resolver führen kann, was aber auch die Anforderungen an die Auswerteelektronik erhöhen würde. Abgesehen davon stellt ein Erregersignal mit großer Amplitude auch eine höhere Anforderung an die Erzeugung des Erregersignals.

Es sind daher im Stand der Technik schon Methoden zur rauschoptimierten Auswertung der Messignale aus dem Revolver bekannt geworden. Ein Beispiel hierfür ist Guo M. et al., "Noise Reduction for High-Accuracy Automatic Calibration of Resolver Signals via DVVT SVD Based Filter", Electronics 2019, 8(5):516. Darin wird die Hüllkurve des Messignals einer diskreten Wavelet Transformation unterzogen, um das Rauschen zu filtern. Dieses Verfahren ist rechentechnisch aufwendig, was für viele Anwendungen nachteilig ist. Trotz der rauschoptimierten Auswertung, muss natürlich auch bei diesem Verfahren ein bestimmter SNR vorhanden sein, um überhaupt eine Auswertung zu ermöglichen.

Es hat sich in der Praxis gezeigt, dass insbesondere schmalbandige (bezogen auf den Frequenzgehalt) Störquellen, die beispielsweise durch induktive oder kapazitive Einkopplungen hervorgerufen werden, problematisch sein können, weil der SNR in diesen Frequenzbereichen sehr klein werden kann. Solche Störquellen sind aber vorab nicht bekannt. Damit kann die erreichbare Präzision der ermittelten Lageinformation sinken. Das kommt insbesondere bei Systemen vor, wo der Resolver und die Auswerteelektronik örtlich getrennt sind und beispielsweise durch ein Kabel miteinander verbunden sind. Solche Systeme sind aufgrund der Übertragung der Messignale über das Kabel besonders störempfindlich, weil es am Kabel zu Einkopplungen von Störsignalen von unterschiedlichsten Störquellen kommen kann.

Resolver sind aus der DE 60 2004 005 672 T2, DE 10 2007 011 064 A1 oder EP 1 158 276 A1 bekannt. In der DE 60 2004 005 672 T2 wird ein Erfassungssignal bei einer Resonanzfrequenz des Resolvers und bei einer Frequenz abseits der Resonanzfrequenz, was ein Störsignal repräsentiert, erfasst. Das Erfassungssignal bei Resonanzfrequenz wird durch das Störsignal verbessert. Das bedingt aber ein breitbandiges Störsignal mit ungefähr gleichbleibenden Störpegel. In der DE 10 2007 011 064 A1 wird ein schmalbandiges Filter eingesetzt, das auf die Erregerfrequenz synchronisiert ist, um das Messignal bei Erregerfrequenz zu filtern. Im Falle von Störungen im Bereich der Erregerfrequenz wird auf eine störungsfreie Frequenz ausgewichen. Das bedingt wiederum schmalbandige Störungen, weil es bei breitbandigen Störungen keine störungsfreie Frequenz gibt.

Die oben beschriebenen Probleme treten aber nicht nur bei Resolvern auf, sondern können grundsätzlich bei allen induktiven Positionssensoren mit einer Erregerwicklung und zumindest einer Sekundärwicklung, in der aufgrund des Erregerfeldes der Erregerwicklung das Messignal induziert wird, auftreten. Die Erregerwicklung und die Sekundärwicklung sind relativ zu einander bewegbar, sodass das Messignal positionsabhängig ist.

Es ist eine Aufgabe der gegenständlichen Erfindung ein einfach umsetzbares Verfahren mit erhöhter Präzision der Lageinformation eines induktiven Positionssensore anzugeben.

Diese Aufgabe wird dadurch gelöst, dass aus dem Messignal ein von der Erregerfrequenz abhängiges Frequenzfunktional gebildet wird, das ein Maß für das Rauschsignal darstellt und die Erregerfrequenz des Erregersignals verändert wird, sodass das Frequenzfunktional minimiert oder maximiert wird und die Erregerfrequenz, die das Frequenzfunktional minimiert oder maximiert für das Erregersignal verwendet wird. Durch die Veränderung der Erregerfrequenz kann insbesondere erreicht werden, dass die Erregung in einem Frequenzbereich stattfindet, in dem das Rauschsignal möglichst schwach ist. Damit wird das Nutzsignal in diesem Frequenzbereich durch das Rauschsignal möglichst wenig gestört und das Nutzsignal kann bestmöglich extrahiert werden, weil das Signal-Rauschverhältnis in diesem Frequenzbereich hoch ist. Damit kann das Erregersignal des induktiven Positionssensors optimal an eine bestimmte Anwendung angepasst werden und die Präzision der Lageinformation kann verbessert werden.

Vorteilhafterweise wird mit dem Frequenzfunktional eine Amplitude des Messignals hinsichtlich einer Abweichung vom erwarteten Signalverlauf des Messignals untersucht, da sich das Rauschsignal unmittelbar in der Amplitude bemerkbar macht. Das kann dadurch gemacht werden, dass aus dem Messsignal eine Amplitudeninformation der Amplitude des Messsignals abgeleitet wird und das Frequenzfunktional eine Funktion der Amplitudeninformation ist.

Besonders vorteilhaft wird das Messsignal demoduliert um die Amplitudeninformation zu ermitteln. Nachdem das Messsignal ein amplitudenmoduliertes Signal ist, kann durch Demodulation auf einfache Weise signaltechnisch die Amplitudeninformation gewonnen werden. Hierzu können bekannte Verfahren, wie beispielsweise das IQ-Verfahren verwendet werden.

Beim IQ-Verfahren werden der, die Amplitude repräsentierende I-Anteil und der, die Phase repräsentierende Q-Anteil des Messsignals ermittelt. Dabei ist es vorteilhaft, wenn eine Phasenverschiebung des Erregersignals eingestellt wird, sodass der I-Anteil des Messsignals maximal wird, und dabei der Q-Anteil verschwindet.

Für die Implementierung der Positionserfassung ist es vorteilhaft, wenn als Frequenzfunktional eine statistische Varianz der Amplitudeninformation verwendet wird. Das lässt sich besonders vorteilhaft in digitaler Implementierung realisieren, wenn die statistische Varianz als die zu erwartende quadratische Abweichung des Wertes der Amplitudeninformation vom Erwartungswert der Amplitudeninformation ermittelt wird, wobei als Erwartungswert vorzugsweise ein arithmetisches Mittel der Amplitudeninformation verwendet wird. Dabei kann als Varianz eine Kurzzeitvarianz über eine Vielzahl von abgetasteten Amplitudenwerten verwendet werden.

Die gegenständliche Erfindung wird nachfolgend unter Bezugnahme auf die Figuren 1 bis 7 näher erläutert, die beispielhaft, schematisch und nicht einschränkend vorteilhafte Ausgestaltungen der Erfindung zeigen. Dabei zeigt

Fig.1 und 2 das Messprinzip eines Resolvers als induktiver Positionssensor,
Fig.3 ein Frequenzspektrum eines Rauschsignals,
Fig.4 ein erfindungsgemäßes Frequenztuning der Erregerfrequenz des Erregersignals,
Fig.5 ein erfindungsgemäßes Phasentuning,
Fig.6 ein erfindungsgemäßes Amplitudentuning und
Fig.7 eine vorteilhafte Implementierung einer Auswerteeinheit mit Frequenztuning, Phasentuning und Amplitudentuning.

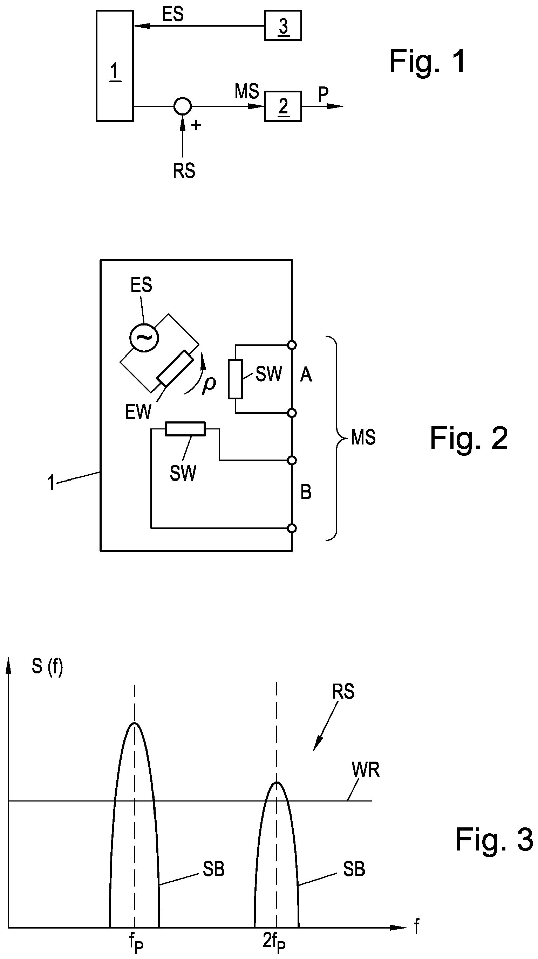

Fig.1 und 2 zeigen das Prinzip eines induktiven Positionssensors 1 am Beispiel eines herkömmlichen Resolvers. Der Resolver hat eine Erregerwicklung EW, die mit einem Erregersignal ES angeregt wird. Das Erregersignal ES wird mit einer Erzeugungseinheit 3, beispielsweise eine elektrische oder elektronische Schaltung, erzeugt. Das Erregersignal ES ist ein elektrisches Wechselsignal mit einer bestimmten Erregeramplitude R0 und Erregerfrequenz ω, also z.B. ES=R0 cos(wt), wobei t die Zeit bezeichnet. Bewegt sich die Erregerwicklung EW relativ zu einer Sekundärwicklung SW, so wird in der Sekundärwicklung SW eine elektrische Spannung induziert, die abhängig von der Position P (in diesem Beispiel der Winkel ρ) der Sekundärwicklung SW zur Erregerwicklung EW ist. In einem Resolver sind beispielsweise zwei Sekundärwicklungen SW 90° versetzt zueinander angeordnet (Fig.2) und die Erregerwicklung EW rotiert im Resolver. An sich würde aber auch nur eine Sekundärwicklung SW ausreichen. Bei einem linearen induktiven Positionssensor 1 wäre eine lineare Relativbewegung zwischen Erregerwicklung EW und Sekundärwicklung SW vorgesehen, wobei auch mehrere Sekundärwicklungen in Bewegungsrichtung hintereinander angeordnet sein können. Die in der zumindest einen Sekundärwicklung SW induzierte Spannung wird als Messignal MS des induktiven Positionssensors 1 ausgegeben und kann in einer Auswerteeinheit 2 ausgewertet werden, um daraus eine Position P des bewegten Teils des induktiven Positionssensors 1, üblicherweise die Erregerwicklung EW, zu ermitteln.

Im Falle eines Resolvers mit zwei Sekundärwicklungen SW umfasst das Messsignal MS zwei Messsignalspuren A, B. Aufgrund der versetzten Anordnung der Sekundärwicklungen SW haben die Messsignalspuren A, B einen bestimmten Phasenversatz.

Die Erregerwicklung EW ist in einem induktiven Positionssensor 1 an einem bewegten Teil angeordnet, beispielsweise an einer Motorwelle eines Elektromotors, und die zumindest eine Sekundärwicklung SW ist an einem ortsfesten Teil, beispielsweise an einem Gehäuse des Positionssensors 1, das wiederum an einem Motorgehäuse angeordnet sein kann. Diese Anordnung kann aber auch umgekehrt sein. Der bewegte Teil und der ortsfeste Teil sind relativ zu einander bewegbar angeordnet.

Bei einem Resolver als induktiven Positionssensor 1 und einem Erregersignal ES=R0·cos(φ), mit φ=ωt, sowie einer 90° versetzten Anordnung der Sekundärwicklungen SW ergeben sich die Messsignalspuren A, B im Messsignal MS beispielsweise zu

$$A = R0 \cdot u \cdot \cos(\rho) \cdot \cos(\varphi - \Delta\varphi)$$

$$B = R0 \cdot u \cdot \sin(\rho) \cdot \cos(\varphi - \Delta\varphi)$$

Darin bezeichnet u ein bekanntes Übertragungsverhältnis des induktiven Positionssensors 1 und $\Delta\varphi$ eine Verzögerung, die sich im Wesentlichen aus einer Laufzeit des induktiven Positionssensors 1 und der Aufbereitung des Messignals MS in der Auswerteeinheit 2 (z.B. durch Filter und Ähnliches) ergibt. Die Verzögerung $\Delta\varphi$ folgt damit als $\Delta\varphi=\omega\Delta t + \varphi_V$, mit einer Verzögerung $\varphi_V$ die sich aus der Aufbereitung ergibt, und der Laufzeit $\Delta t$.. $\rho$ bezeichnet die Winkellage der Erregerwicklung EW bezogen auf die Sekundärwicklungen SW (angedeutet in Fig.2) und damit die eigentliche interessierende Position P.

Bei anderen Anordnungen eines induktiven Positionssensors 1 kann das Messsignal MS natürlich auch anders aussehen, auch mit mehr oder weniger Messignalspuren, wobei das Messsignal MS aber immer abhängig von der Position P ist, also MS(P). Das Messsignal MS umfasst zumindest eine Messsignalspur A, B.

Dieses Prinzip eines induktiven Positionssensors 1 ist an sich hinlänglich bekannt. Bekannt ist auch, dass dem Messsignal MS üblicherweise ein Rauschsignal RS überlagert ist, wie in Fig.1 angedeutet ist. Das Rauschsignal RS ist üblicherweise nicht bekannt und kann verschiedene Frequenzbänder umfassen. Das Rauschsignal RS kann beispielsweise ein weißes Rauschen WR sein, das auch schmale Störbänder SB in bestimmten Frequenzbereichen umfasst. Das ist beispielshaft in Fig.3 anhand eines Frequenzspektrums S(f) (Frequenz f) des Rauschsignals RS dargestellt. Diese schmalbandigen Störbänder SB um charakteristische Frequenzen $f_P$, $2f_P$ können aus der Umgebung in das Messsignal MS eingekoppelt werden (z.B. induktiv). Das Rauschsignal RS kann aber natürlich auch ein anders Frequenzspektrum S(f) aufweisen. Das Rauschsignal RS bestimmt maßgeblich das Signal-Rausch-Verhältnis des Messsignals MS. Um das eigentliche Nutzsignal aus dem Messsignal MS (z.B. die Messsignalspuren A, B) extrahieren zu können, ist ein möglichst großes Signal-Rausch-Verhältnis vorteilhaft, also ein großer Abstand zwischen dem eigentlichen Nutzsignal im Messignal MS und dem Rauschsignal RS.

Die grundlegende Idee der Erfindung liegt darin, ein von der Erregerfrequenz $\omega$ abhängiges Frequenzfunktional $F_f$ als Maß für das Rauschsignal RS im Messsignal MS zu verwenden und die Erregerfrequenz $\omega$ zu verändern, sodass das Frequenzfunktional $F_f$ optimiert wird, was je nach Formulierung des Frequenzfunktionals $F_f$ einer Maximierung oder Minimierung entspricht. Die Erregerfrequenz $\omega$, die das Frequenzfunktional $F_f$ minimiert oder maximiert wird dann im Erregersignal ES für den Betrieb des induktiven Positionssensors 1 verwendet.

Das Frequenzfunktional $F_f$ als Maß für das Rauschsignal RS im Messsignal MS ermöglicht damit Information zum Rauschsignal RS im Messsignal MS zu erhalten. Das Maß ist beispielsweise eine Größe, die das Rauschsignal RS mit dem Messsignal MS vergleicht oder dazu in Verhältnis stellt. Das Frequenzfunktional $F_f$ kann mathematisch als mathematische Funktion der Erregerfrequenz $\omega$ formuliert werden.

Das Frequenzfunktional $F_f$ kann natürlich auf verschiedenste Weisen formuliert sein, beispielsweise als Signal-Rausch-Verhältnis, wenn man das Rauschsignal RS vom Messsignal MS trennen kann, beispielsweise durch Filterung. Man kann mit einem Frequenzfunktional $F_f$ auch die Amplitude des Messsignals MS (konkret zumindest einer Messsignalspur) hinsichtlich einer Abweichung vom erwarteten Signalverlauf des Messsignals MS untersuchen. Diese Abweichung ist ein Maß für das Rauschsignal RS. Beim Resolver wäre das beispielsweise eine modulierte Sinusschwingung, wobei sich ein Rauschen als Abweichung von dieser modulierten Sinusschwingung bemerkbar macht. Hierfür könnte beispielsweise als Frequenzfunktional $F_f$ eine statistische Varianz der Amplitude des Messsignals als Maß für diese Abweichung, und damit als Maß für das Rauschsignal RS, verwendet werden. Dazu kann aus dem Messsignal MS, bzw. aus zumindest einer Messsignalspur des Messsignals MS, eine Amplitudeninformation FA der Amplitude des Messsignals MS abgeleitet werden, die dann im Frequenzfunktional $F_f$ ausgewertet wird. Die Amplitudeninformation FA kann dabei abhängig von der Erregerfrequenz $\omega$ sein. Das Frequenzfunktional $F_f$ ist damit eine Funktion der Amplitudeninformation FA, also $F_f(FA(\omega))$, und ist damit abhängig von der Erregerfrequenz $\omega$.

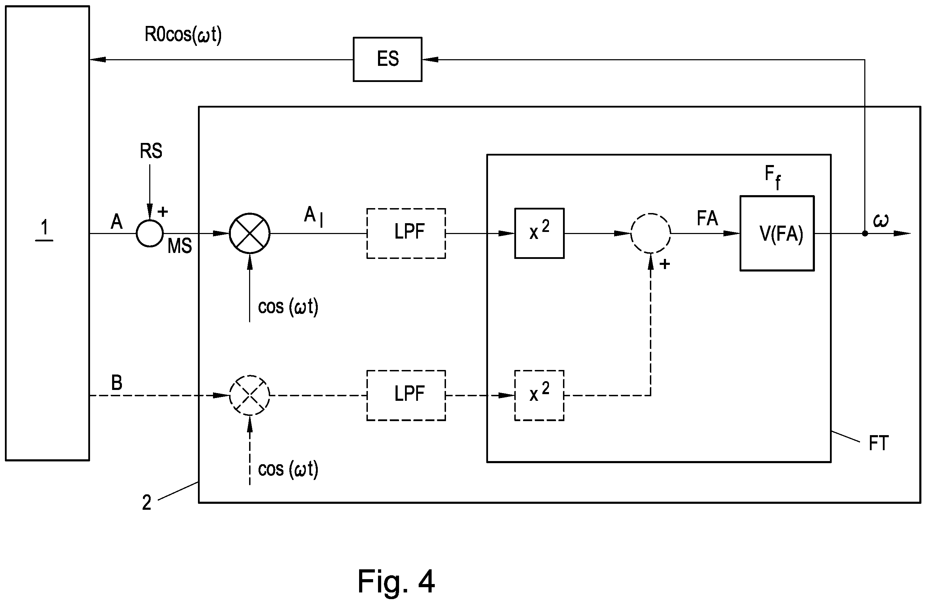

Eine besonders vorteilhafte Ausgestaltung der Erfindung wird anhand der Fig.4 erläutert. Bei diesem Verfahren wird die zumindest eine Messsignalspur A, B demoduliert, um das Nutzsignal zu gewinnen, also die in Abhängigkeit von der Position P schwingende Größe, beispielsweise $\cos(\rho)$ oder $\sin(\rho)$. Aus einer solchen Demodulation kann die Amplitudeninformation FA des Messsignals MS gewonnen werden, aus der dann ein Frequenzfunktional $F_f$ wie oben beschrieben gebildet werden kann. Nachdem das Erregersignal ES und das Messsignal MS aufgrund einer zeitlichen Verzögerung $\Delta\varphi$ üblicherweise eine Phasenverschiebung aufweisen, bietet sich zur Demodulation das bekannte IQ-Verfahren (In-Phase-&-Quadrature-Verfahren) an, da man damit sowohl die Amplitudeninformation, als auch die Phaseninformation gewinnen kann. Zur Demodulation wird das Messsignal MS mit der Erregerschwingung $\cos(\omega t)$ multipliziert, um den die Amplitude repräsentierenden I-Anteil zu erhalten. Wird das Messsignal MS optional auch mit der 90° phasenverschobenen Erregerschwingung multipliziert, erhält man auch die Phaseninformation (Q-Anteil). Mathematisch kann das im Falle eines Resolvers in Form der periodischen Skalarprodukte ausgedrückt werden, wobei allgemein zumindest eine Messsignalspur A, B, vorhanden ist.

$$A_I = \left( A \mid \cos(\varphi) \right) = \frac{1}{2} R0 \cdot u \cdot \cos(\rho) \cdot \cos\left( \Delta\varphi \right)$$

$$B_I = \left( B \mid \cos(\varphi) \right) = \frac{1}{2} R0 \cdot u \cdot \sin(\rho) \cdot \cos\left(\Delta\varphi\right)$$

Und optional bzw. bedarfsweise

$$A_Q = \left( A \mid \sin(\varphi) \right) = \frac{1}{2} R0 \cdot u \cdot \cos(\rho) \cdot \sin\left(\Delta\varphi\right)$$

$$B_Q = \left( B \mid \sin(\varphi) \right) = \frac{1}{2} R0 \cdot u \cdot \sin(\rho) \cdot \sin\left(\Delta\varphi\right)$$

Der I-Anteil $A_I$, $B_I$ enthält die Amplitudeninformation FA und kann für die weitere Verwendung auch quadriert werden $FA = A_I{}^2$, oder alternativ könnte auch der Betrag $FA = |A_I|$ verwendet werden. Bei mehreren Messsignalspuren A, B kann auch die Summe der Quadrate $FA = A_I{}^2 + B_I{}^2$ der I-Anteile $A_I$, $B_I$, oder alternativ auch die Summe der Beträge $FA = |A_I| + |B_I|$ verwendet werden. Auch andere arithmetische Verknüpfungen der I-Anteile sind grundsätzlich denkbar.

Als Frequenzfunktional $F_f$ kann dann beispielsweise eine statistische Varianz V der Amplitudeninformation FA verwendet werden, die abhängig von der Erregerfrequenz $\omega$ ist.

Die Varianz V kann als die zu erwartende quadratische Abweichung (also der Erwartungswert E) des Wertes der Amplitudeninformation FA von seinem Erwartungswert E(FA) angeben werden. Als Erwartungswert E(FA) kann das arithmetische Mittel verwendet werden. Mathematisch kann das in der Form

$$F_f = V\left(FA\right) = E\left(\left(FA - E(FA)\right)^2\right)$$

ausgedrückt werden.

Für die Ermittlung der Varianz V werden vorzugsweise eine Vielzahl N von Werten der Amplitudeninformation FA verwendet, die durch Abtastung des Messsignals MS mit einer vorgegebenen Abtastfrequenz (z.B. im Megaherz-Bereich) erhalten werden können. Bei einer typischen Erregerfrequenz von 10kHz ergäbe eine Abtastfrequenz von 1 MHz eine hundertfache Überabtastung. Die Varianz V lässt sich damit als Kurzzeitvarianz ausdrücken in der Form

$$F_f = V\left(FA\right) \approx \frac{1}{N-1} \sum_{i=0}^{N-1} \left( FA_i - \frac{1}{N} \sum_{i=0}^{N-1} FA_i \right)^2.$$

Für die Ermittlung werden beispielsweise 1.000 bis 10.000 Perioden des Erregersignals ES verwendet, was zu einem Beobachtungszeitraum zur Ermittlung eines Wertes der Varianz V von 100ms bis 1s führen würde.

Das Frequenzfunktional $F_f$ wird nun hinsichtlich der Erregerfrequenz $\omega$ optimiert, was mathematisch durch

$$\omega = \underset{\omega}{\min}\left(F_f\right) \qquad \omega = \underset{\omega}{\max}\left(F_f\right)$$

oder ausgedrückt werden kann. Es wird die Erregerfrequenz $\omega$ somit variiert, bis das Funktional $F_f$ optimiert (im Sinne eines Minimums oder Maximums) ist. Die Erregerfrequenz $\omega$ wird dabei innerhalb eines vorgegebenen Frequenzbereichs variiert.

Um derartige Optimierungsprobleme zu lösen, gibt es eine Fülle von bekannten Lösungsalgorithmen, wie beispielsweise das Gradientenverfahren, das Newton Verfahren, evolutionäre Verfahren oder sequentielle quadratische Programmierung, um nur einige zu nennen. Die Wahl des Lösungsalgorithmus spielt für die Erfindung aber keine Rolle, wobei man aber natürlich ein solches Verfahren wählen wird, das hinsichtlich Rechenaufwand und Rechenzeit vorteilhaft ist. Den Lösungsverfahren ist gemein, dass, üblicherweise iterativ, mögliche Lösungen des Optimierungsproblems gesucht werden, bis ein definiertes Abbruchkriterium erreicht wird. Das Abbruchkriterium kann beispielsweise eine Anzahl von Iterationen sein, oder das Unterschreiten eines Grenzwertes der Differenz der Lösungen zweier aufeinanderfolgender Iterationsschritte des Optimierungsproblems, oder auch ein anderes Abbruchkriterium. Die Auswahl der Lösungen (also Erregerfrequenzen $\omega$) in jedem Iterationsschritt erfolgt durch die vorgegebenen Regeln des Lösungsverfahrens, wobei im ersten Iterationsschritt eine geeignete Wahl der Lösung als Startwert vorgegeben werden kann. Beim Gradientenverfahren ermittelt man beispielsweise den Gradienten des Funktionals (Ableitung des Funktionals nach der Erregerfrequenz) und wählt die Stellgröße für den nächsten Iterationsschritt entlang dieses Gradienten, wobei die Schrittweite von der aktuellen Stellgröße zur nächsten Stellgröße durch die vorgegebenen Regeln des Lösungsverfahrens bestimmt wird.

Auf diese Weise kann die Erregerfrequenz $\omega$ ermittelt werden, mit der der induktive Positionssensor 1 angeregt werden muss, damit der Einfluss des Rauschsignals RS minimal wird. Damit lassen sich insbesondere schmalbandige Störbänder umgehen. Würde man die Erregerfrequenz $\omega$ beispielsweise im Bereich der Frequenz $f_P$ (oder ganzzahliger Vielfacher davon) wählen (Fig.3), dann würde das Signal-Rausch-Verhältnis des Messsignals MS gegenüber einer Erregerfrequenz $\omega$ abseits davon sinken.

Eine mögliche Implementierung eines erfindungsgemäßen Frequenztunings wie oben beschrieben ist in Fig.4 dargestellt. Das Beispiel betrifft wieder einen Resolver mit zumindest einer Messsignalspur A im Messsignal MS.

Die Messsignalspur A wird zuerst demoduliert und der I-Anteil $A_I$ ermittelt, der quadriert wird, um die Amplitudeninformation FA zu ermitteln. Das kann in einem Frequenztuner FT erfolgen. Strichliert ist in Fig.4 eine zweite Messsignalspur B angedeutet, wie bei Resolvern üblich. Die Amplitudeninformation FA wäre dann in diesem Beispiel die Summe der quadrierten I-Anteile $A_I$, $B_I$ der Messsignalspuren A, B. Als Frequenzfunktional $F_f$ wird die Varianz V(FA) der Amplitudeninformation FA verwendet, beispielsweise als Kurzzeitvarianz wie oben beschrieben. Das Frequenzfunktional $F_f$ wird hinsichtlich der Erregerfrequenz $\omega$ minimiert und der induktive Positionssensor 1 wird darauffolgend mit dieser Erregerfrequenz $\omega$ betrieben. Das gewährleistet in der jeweiligen Anwendung mit der vorherrschenden Störumgebung ein größtmögliches Signal-Rausch-Verhältnis.

In Fig.4 sind auch Tiefpassfilter LPF nach der Ermittlung der I-Anteile $A_I$, $B_I$ angedeutet. Ein solches Tiefpassfilter LPF könnte verwendet werden, um die sich bei der Demodulation ergebenden doppelten Erregerfrequenzen $\omega$ zu unterdrücken.

Dieses Frequenztuning könnte einmalig bei Inbetriebnahme des induktiven Positionssensor 1 durchgeführt werden und die Erregerfrequenz $\omega$ könnte dann, unter der Annahme einer sich nicht verändernden Störumgebung gleich belassen werden. Dabei wäre lediglich dafür Sorge zu tragen, dass während des Frequenztunings die Störquellen in der Umgebung aktiv sind.

Das Frequenztuning könnte aber auch laufend im Betrieb des induktiven Positionssensors 1 durchgeführt werden, beispielsweise in vorgegebenen Zeitintervallen.

Ein laufendes Frequenztuning könnte beispielsweise so funktionieren, dass laufende eine Spektralanalyse der zumindest einen Messsignalspur A, B durchgeführt wird, beispielsweise mittels einer FFT (Fast Fourier Transformation) und im Frequenzspektrum als Frequenzfunktional $F_f$ die Rauschleistungsdichte des Rauschsignals RS quantifiziert wird. Das Minimum der Rauschleistungsdichte kann dabei identifiziert werden und die Erregerfrequenz $\omega$ kann dann an der Stelle mit der minimalen Rauschleistungsdichte gesetzt werden.

Das erfindungsgemäße Frequenztuning könnte auch mit einem Phasentuning kombiniert werden. Damit kann erreicht werden, dass die I-Anteile $A_I$, $B_I$ der demodulierten Messsignalspuren A, B maximal werden (was für das Frequenztuning vorteilhaft ist) und die Q-Anteile $A_Q$, $B_Q$ verschwinden. Das kann beispielsweise mit einem Phasenregler $R_\varphi$ durchgeführt werden, der eine Phasenverschiebung $\Delta\varphi$ des Erregersignals ES regelt, sodass die Q-Anteile $A_Q$, $B_Q$ verschwinden.

Das kann bei einem Resolver beispielsweise derart realisiert werden, indem ein Phasenfunktional $F_\varphi = A_I A_Q + B_I B_Q$ verwendet wird, wobei darin wieder die Skalarprodukte verwendet werden.

$$F_\varphi = \frac{1}{8} R0^2 u^2 \sin(2\Delta\varphi)$$

Dieses Phasenfunktional $F_\varphi$ ist von der Position $\rho$ unabhängig und ergibt sich zu . Diese Funktion hat im Intervall $\Delta\varphi \in [0, 2\pi[$ vier Nullstellen, wobei in zwei davon (bei $\pi/2$, $3\pi/2$) die I-Anteile $A_I$, $B_I$ verschwinden und die Q-Anteile $A_Q$, $B_Q$ maximal sind und in den beiden anderen Nullstellen (bei 0, $\pi$) die Q-Anteile $A_Q$, $B_Q$ verschwinden und die I-Anteile $A_I$, $B_I$ maximal sind.

Ein Phasenregler $R_\varphi$ kann nun das Phasenfunktional $F_\varphi$ auf null regeln, also $F_\varphi = 0$, wobei der Phasenregler $R_\varphi$ dafür sorgt, dass die Phasenverschiebung $\Delta\varphi$ bei 0 oder $\pi$ einrastet. Der Phasenregler $R_\varphi$ kann beispielsweise als bekannter I-Regler (Integralregler) ausgeführt sein.

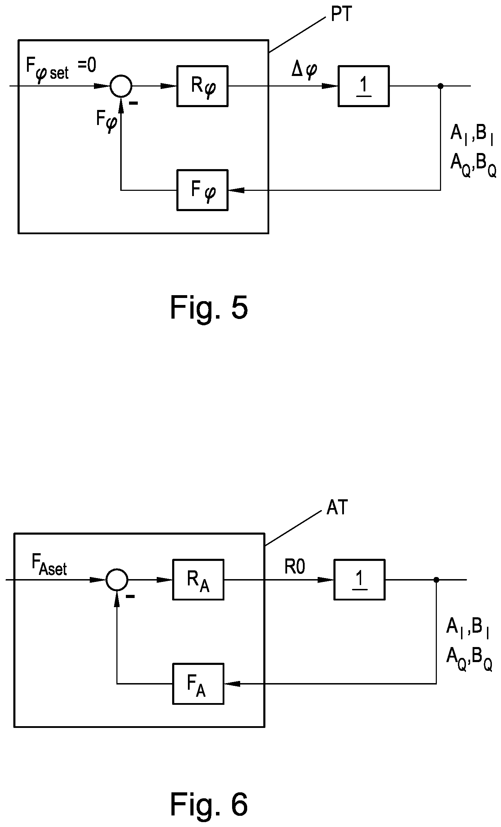

Der Phasentuner PT kann wie in Fig.5 dargestellt implementiert sein. Der Phasensollwert $F_{\varphi set}$ wird auf null gesetzt, sodass die Phasenverschiebung $\Delta\varphi$ durch den Phasenregler $R_\varphi$ geregelt wird, sodass das Phasenfunktional $F_\varphi$ zu null wird. Die Phasenverschiebung $\Delta\varphi$ wird dann im Erregersignal ES eingestellt.

Das erfindungsgemäße Frequenztuning könnte auch mit einem Amplitudentuning kombiniert werden, gegebenenfalls auch in Kombination mit dem Phasentuning. Die Idee des Amplitudentuning liegt darin, dass die Erregeramplitude R0 des Erregersignals ES auf einen maximalen Wert gesetzt wird. Dieser maximale Wert ist von der Implementierung der Erzeugungseinheit 3 für das Erregersignal ES abhängig. Beispielsweise kann die Amplitude R0 auf einen Wert gesetzt werden, sodass der volle Linearitätsbereich einer Elektronikschaltung als Erzeugungseinheit 3 ausgeschöpft wird. Das kann beispielsweise mit einem Amplitudenregler $R_A$ durchgeführt werden, der die Erregeramplitude R0 auf einen vorgegebenen Sollwert regelt.

Das kann bei einem Resolver beispielsweise derart realisiert werden, indem ein Amplitudenfunktional $F_A = A_I^2 + B_I^2 + A_Q^2 + B_Q^2$ verwendet wird. Wird zusätzlich das oben beschriebene Phasentuning verwendet, verschwinden im Amplitudenfunktional $F_A$ die Terme mit den Q-Anteilen. Dieses Amplitudenfunktional $F_A$ ist sowohl von der Position $\rho$, als auch von der Phasenverschiebung $\Delta\varphi$ unabhängig und ergibt sich mit den obigen Definitionen der I- und Q-Anteile zu $$F_A = \frac{1}{4} R0 \cdot u$$ .

Ein Amplitudenregler Ra, kann nun das Amplitudenfunktional $F_A$ auf einen vorgegebenen Amplitudensollwert $F_{Aset}$ regeln. Der Amplitudensollwert $F_{Aset}$ kann sich dabei aus einer Implementierung der Erzeugungseinheit 3 ergeben. Der Amplitudenregler Ra, kann beispielsweise als bekannter I-Regler (Integralregler) ausgeführt sein.

Der Amplitudentuner AT kann wie in Fig.6 dargestellt implementiert sein. Die Erregeramplitude R0 wird dann im Erregersignal ES eingestellt.

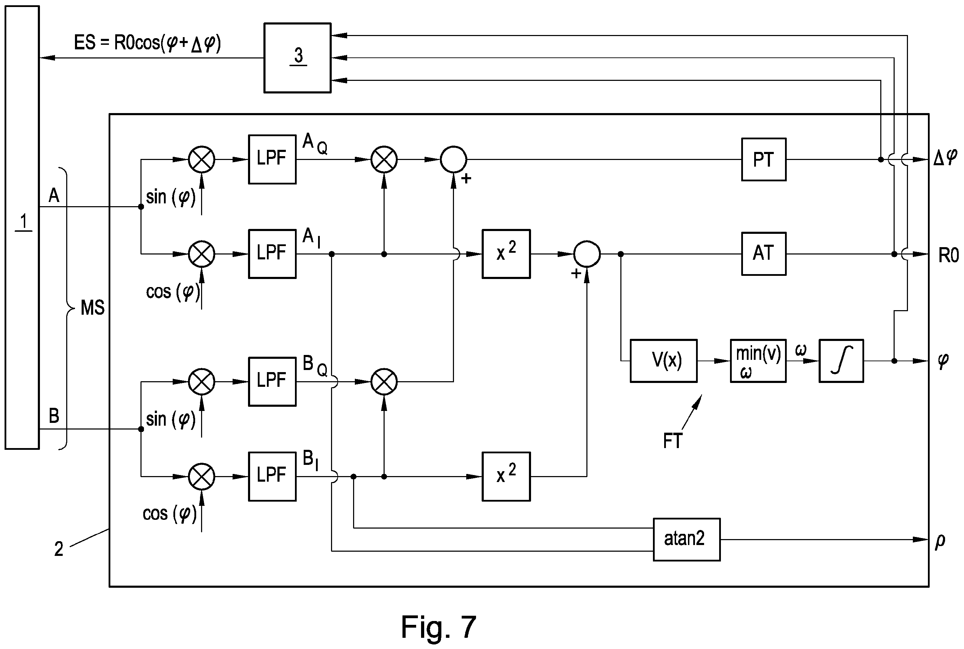

Fig.7 zeigt eine vorteilhafte Positionsbestimmung mit einem Resolver als induktiver Positionssensor 1. Der Resolver wird mit einem Erregersignal ES mit einer Erregerfrequenz $\omega$, einer Phasenverschiebung $\Delta\varphi$ und einer Erregeramplitude R0 angeregt. Die vom Resolver ausgegebenen Messsignalspuren A, B, des Messsignals MS werden in einer Auswerteeinheit 2 ausgewertet. Die Messsignalspuren A, B werden mit einem IQ-Verfahren demoduliert, und die I-Anteile $A_I$, $B_I$, sowie die Q-Anteile $A_Q$, $B_Q$ ermittelt. Aus dem I- und Q-Anteilen $A_I$, $B_I$, $A_Q$, $B_Q$ werden das Frequenzfunktional $F_f$, das Phasenfunktional $F_\varphi$ und das Amplitudenfunktional $F_A$ ermittelt. Die Erregerfrequenz $\omega$ wird dann mit einem Frequenztuner FT eingestellt, in dem das oben beschriebene erfindungsgemäße Frequenztuning implementiert ist. Gleichfalls wird mit einem Phasentuner PT die Phasenverschiebung $\Delta\varphi$ des Erregersignals ES eingestellt und mit einem Amplitudentuner AT die Erregeramplitude R0.

Aus den I-Anteilen $A_I$, $B_I$ (oder optional aus den Q-Anteilen $A_Q$, $B_Q$) kann natürlich noch die Position P, in diesem Fall ein Winkel $\rho$, bestimmt werden, beispielsweise mit der atan2-Funktion.

Die Implementierung der Auswerteeinheit 2 erfolgt vorzugsweise digital, als Software auf einer mikroprozessorbasierten Hardware. Alternativ kommt auch eine Implementierung auf einem integrierten Schaltkreis, beispielsweise als Field Programmable Gate Array (FPGA) oder Anwendungsspezifische integrierte Schaltung (ASIC) in Frage. Auch eine analoge Implementierung ist natürlich nicht ausgeschlossen.

In einer digitalen Implementierung werden die vom Positionssensor 1 ausgegeben Messsignalspuren A, B mit geeigneten Analog-/Digitalwandlern (ADC) analog/digital gewandelt. Gleichfalls kann das Erregersignal ES digital erzeugt werden und mittels Digital/Analogwandler (DAC) an den Positionssensor 1 angelegt werden. Auch der Positionswert P kann analog oder digital ausgegeben werden.

**Patentansprüche**

1. Verfahren zur Bestimmung der Position (P) eines bewegten Teils relativ zu einem ortsfesten Teil mittels eines induktiven Positionssensors (1), wobei am bewegten Teil eine Erregerwicklung (EW) angeordnet ist und am ortsfesten Teil zumindest eine Sekundärwicklung (SW), oder umgekehrt, und in die Erregerwicklung (EW) ein elektrisches Erregersignal (ES) mit einer Erregerfrequenz ($\omega$) und einer Erregeramplitude (R0) eingespeist wird, das ein elektromagnetisches Erregerfeld erzeugt, das in der Sekundärwicklung (SW) ein Messsignal (MS) induziert, das erfasst wird, und dem Messsignal (MS) ein Rauschsignal (RS) überlagert ist, und wobei aus dem Messsignal (MS) die Position (P) des bewegten Teils des Positionssensors (1) ermittelt wird, **dadurch gekennzeichnet, dass** aus dem Messsignal (MS) ein von der Erregerfrequenz ($\omega$) abhängiges Frequenzfunktional ($F_f$) gebildet wird, das ein Maß für das Rauschsignal (RS) darstellt **und dass** die Erregerfrequenz ($\omega$) des Erregersignals (ES) verändert wird, sodass das Frequenzfunktional ($F_f$) minimiert oder maximiert wird und die Erregerfrequenz ($\omega$), die das Frequenzfunktional ($F_f$) minimiert oder maximiert, für das Erregersignal (ES) verwendet wird.

2. Verfahren nach Anspruch 1, **dadurch gekennzeichnet, dass** mit dem Frequenzfunktional ($F_f$) eine Amplitude des Messignals (MS) hinsichtlich einer Abweichung vom erwarteten Signalverlauf des Messsignals (MS) untersucht wird.

3. Verfahren nach Anspruch 1 oder 2, **dadurch gekennzeichnet, dass** aus dem Messsignal (MS) eine Amplitudeninformation (AI) der Amplitude des Messsignals (MS) abgeleitet wird und das Frequenzfunktional ($F_f$) eine Funktion der Amplitudeninformation (AI) ist.

4. Verfahren nach Anspruch 3 , **dadurch gekennzeichnet, dass** das Messsignal (MS) demoduliert wird, um die Amplitudeninformation (AI) zu ermitteln.

5. Verfahren nach Anspruch 3 oder 4, **dadurch gekennzeichnet, dass** das Messsignal (MS) mit der Erregerschwingung des Erregersignals (ES) demoduliert wird, um die Amplitudeninformation (AI) zu ermitteln.

6. Verfahren nach Anspruch 5, **dadurch gekennzeichnet, dass** das Messsignal (MS) mit der Erregerschwingung des Erregersignals (ES) demoduliert wird, um einen die Amplitude repräsentierenden I-Anteil ($A_I$, $B_I$) des Messsignals (MS) zu ermitteln.

7. Verfahren nach Anspruch 5, **dadurch gekennzeichnet, dass** das Messsignal (MS) mit der um 90° phasenverschobenen Erregerschwingung des Erregersignals (ES) demoduliert wird, um einen die Phase repräsentierenden Q-Anteil des Messsignals (MS) zu ermitteln.

8. Verfahren nach einem der Ansprüche 3 bis 6, **dadurch gekennzeichnet, dass** als Frequenzfunktional ($F_f$) eine statistische Varianz (V) der Amplitudeninformation (AI) verwendet wird.

9. Verfahren nach Anspruch 8, **dadurch gekennzeichnet, dass** die statistische Varianz (V) als die zu erwartende quadratische Abweichung des Wertes der Amplitudeninformation (AI) vom Erwartungswert der Amplitudeninformation (AI) ermittelt wird, wobei als Erwartungswert vorzugsweise ein arithmetisches Mittel der Amplitudeninformation (AI) verwendet wird.

10. Verfahren nach Anspruch 6, **dadurch gekennzeichnet, dass** eine Phasenverschiebung ($\Delta\varphi$) des Erregersignals (ES) eingestellt wird, sodass die I-Anteile ($A_I$, $B_I$) des Messsignals maximal werden.

11. Verfahren nach einem der Ansprüche 1 bis 10, **dadurch gekennzeichnet, dass** die Erregeramplitude (R0) auf einen vorgegebenen Amplitudensollwert geregelt wird.

12. Auswerteeinheit für einen induktiven Positionssensor (1) mit einem bewegten Teil mit einer Erregerwicklung (EW) und einem ortsfesten Teil mit zumindest einer Sekundärwicklung (SW), oder umgekehrt, wobei in die Erregerwicklung (EW) ein elektrisches Erregersignal (ES) mit einer Erregerfrequenz ($\omega$) und einer Erregeramplitude (R0) eingespeist wird, das ein elektromagnetisches Erregerfeld erzeugt, das in der Sekundärwicklung (SW) ein Messsignal (MS) induziert, das der Auswerteeinheit (2) zugeführt wird und dem Messsignal (MS) ein Rauschsignal (RS) überlagert ist, und wobei die Auswerteeinheit (2) aus dem Messsignal (MS) eine Position (P) des bewegten Teils relativ zum ortsfesten Teil des Positionssensors (1) ermittelt, **dadurch gekennzeichnet, dass** die Auswerteeinheit (2) dazu eingerichtet ist aus dem Messsignal (MS) ein von der Erregerfrequenz ($\omega$) abhängiges Frequenzfunktional ($F_f$) zu bilden, das ein Maß für das Rauschsignal (RS) darstellt **und dass** die Auswerteeinheit (2) dazu eingerichtet ist die Erregerfrequenz ($\omega$) des Erregersignals zu ermitteln, die das Frequenzfunktional ($F_f$) minimiert oder maximiert und die Erregerfrequenz ($\omega$), die das Frequenzfunktional ($F_f$) minimiert oder maximiert, bei Verwendung der Auswerteeinheit (2) für das Erregersignal (ES) verwendet wird.

## Claims

1. Method for determining the position (P) of a moving part relative to a stationary part by means of an inductive position sensor (1), wherein an excitation winding (EW) is arranged on the moving part and at least one secondary winding (SW) is arranged on the stationary part, or vice versa, and an electrical excitation signal (ES) with an excitation frequency ($\omega$) and an excitation amplitude (R0) is fed into the excitation winding (EW), which generates an electromagnetic excitation field that induces a measurement signal (MS) in the secondary winding (SW), which is detected, and a noise signal (RS) is superimposed on the measurement signal (MS), and wherein the position (P) of the moving part of the position sensor (1) is determined from the measurement signal (MS), **characterized in that** a frequency functional ($F_f$) which is dependent on the excitation frequency ($\omega$) and represents a measure of the noise signal (RS) is formed from the measurement signal (MS), **and in that** the excitation frequency ($\omega$) of the excitation signal (ES) is changed so that the frequency functional ($F_f$) is minimized or maximized and the excitation frequency ($\omega$) that minimizes or maximizes the frequency functional ($F_f$) is used for the excitation signal (ES).

2. Method according to claim 1, **characterized in that** the frequency functional ($F_f$) is used to examine an amplitude of the measurement signal (MS) with regard to a deviation from an expected signal curve of the measurement signal (MS).

3. Method according to either claim 1 or 2, **characterized in that** an amplitude information (AI) of the amplitude of the measurement signal (MS) is derived from the measurement signal (MS) and the frequency functional ($F_f$) is a function of the amplitude information (AI).

4. Method according to claim 3, **characterized in that** the measurement signal (MS) is demodulated in order to determine the amplitude information (AI).

5. Method according to either claim 3 or 4, **characterized in that** the measurement signal (MS) is demodulated with the excitation oscillation of the excitation signal (ES) in order to determine the amplitude information (AI).

6. Method according to claim 5, **characterized in that** the measurement signal (MS) is demodulated with the excitation oscillation of the excitation signal (ES) in order to determine an I component ($A_I$, $B_I$) of the measurement signal (MS) representing the amplitude.

7. Method according to claim 5, **characterized in that** the measurement signal (MS) is demodulated with the 90° out-of-phase excitation oscillation of the excitation signal (ES) in order to determine a Q component of the measurement signal (MS) representing the phase.

8. Method according to any of claims 3 to 6, **characterized in that** a statistical variance (V) of the amplitude information (AI) is used as the frequency functional ($F_f$).

9. Method according to claim 8, **characterized in that** the statistical variance (V) is determined as the expected square deviation of the value of the amplitude information (AI) from the expected value of the amplitude information (AI), wherein an arithmetic mean of the amplitude information (AI) is preferably used as the expected value.

10. Method according to claim 6, **characterized in that** a phase shift ($\Delta\varphi$) of the excitation signal (ES) is set so that the I components ($A_I$, $B_I$) of the measurement signal are at a maximum.

11. Method according to any of claims 1 to 10, **characterized in that** the excitation amplitude (R0) is regulated to a predetermined amplitude setpoint.

12. Evaluation unit for an inductive position sensor (1) having a moving part with an excitation winding (EW) and a stationary part having at least one secondary winding (SW), or vice versa, wherein an electrical excitation signal (ES) with an excitation frequency ($\omega$) and an excitation amplitude (R0) is fed into the excitation winding (EW), which generates an electromagnetic excitation field that induces a measurement signal (MS) in the secondary winding (SW) which is fed to the evaluation unit (2) and a noise signal (RS) is superimposed on the measurement signal (MS), and wherein the evaluation unit (2) determines a position (P) of the moving part relative to the stationary part of the position sensor (1) from the measurement signal (MS), **characterized in that** the evaluation unit (2) is arranged to form a frequency functional ($F_f$), which is dependent on the excitation frequency ($\omega$) and represents a measure of the noise signal (RS), from the measurement signal (MS), **and in that** the evaluation unit (2) is arranged to determine the excitation frequency ($\omega$) of the excitation signal (ES) which minimizes or maximizes the frequency functional ($F_f$) and the excitation frequency ($\omega$) which minimizes or maximizes the frequency functional ($F_f$) is used for the excitation signal (ES) when using the evaluation unit (2).

**Revendications**

1. Procédé permettant la détermination de la position (P) d'une pièce en mouvement par rapport à une pièce fixe au moyen d'un capteur de position (1) inductif, un enroulement d'excitation (EW) étant disposé sur la pièce en mouvement et au moins un enroulement secondaire (SW) étant disposé sur la pièce fixe, ou inversement, et un signal d'excitation (ES) électrique comportant une fréquence d'excitation ($\omega$) et une amplitude d'excitation (R0) étant introduit dans l'enroulement d'excitation (EW), lequel signal d'excitation génère un champ d'excitation électromagnétique qui induit un signal de mesure (MS) dans l'enroulement secondaire (SW), lequel signal de mesure est détecté, et un signal de bruit (RS) étant superposé au signal de mesure (MS), et la position (P) de la pièce en mouvement du capteur de position (1) étant déterminée à partir du signal de mesure (MS), **caractérisé en ce qu'**une fonction de fréquence ($F_f$) dépendant de la fréquence d'excitation ($\omega$) est formée à partir du signal de mesure (MS), laquelle fonction de fréquence représente une mesure pour le signal de bruit (RS),
**et en ce que** la fréquence d'excitation ($\omega$) du signal d'excitation (ES) est modifiée de sorte que la fonction de fréquence ($F_f$) est minimisée ou maximisée et la fréquence d'excitation ($\omega$) qui minimise ou maximise la fonction de fréquence ($F_f$) est utilisée pour le signal d'excitation (ES).

2. Procédé selon la revendication 1, **caractérisé en ce que,** au moyen de la fonction de fréquence (Ff), une amplitude du signal de mesure (MS) est examinée en ce qui concerne un écart par rapport à la forme de signal attendue du signal de mesure (MS).

3. Procédé selon la revendication 1 ou 2, **caractérisé en ce qu'**une information d'amplitude (AI) de l'amplitude du signal de mesure (MS) est dérivée du signal de mesure (MS) et la fonction de fréquence ($F_f$) est une fonction de l'information d'amplitude (AI).

4. Procédé selon la revendication 3, **caractérisé en ce que** le signal de mesure (MS) est démodulé afin de déterminer l'information d'amplitude (AI).

5. Procédé selon la revendication 3 ou 4, **caractérisé en ce que** le signal de mesure (MS) est démodulé avec l'oscillation d'excitation du signal d'excitation (ES) afin de déterminer l'information d'amplitude (AI).

6. Procédé selon la revendication 5, **caractérisé en ce que** le signal de mesure (MS) est démodulé avec l'oscillation d'excitation du signal d'excitation (ES) afin de déterminer une composante I ($A_I$, $B_I$) du signal de mesure (MS) représentant l'amplitude.

7. Procédé selon la revendication 5, **caractérisé en ce que** le signal de mesure (MS) est démodulé avec l'oscillation d'excitation du signal d'excitation (ES) déphasée de 90° afin de déterminer une composante Q du signal de mesure (MS) représentant la phase.

8. Procédé selon l'une des revendications 3 à 6, **caractérisé en ce qu'**une variance statistique (V) de l'information d'amplitude (AI) est utilisée comme fonction de fréquence (Ff).

9. Procédé selon la revendication 8, **caractérisé en ce que** la variance statistique (V) est déterminée en tant que l'écart quadratique attendu entre la valeur de l'information d'amplitude (AI) et la valeur attendue de l'information d'amplitude (AI), une moyenne arithmétique de l'information d'amplitude (AI) étant utilisée de préférence comme valeur attendue.

10. Procédé selon la revendication 6, **caractérisé en ce qu'**un déphasage ($\Delta\varphi$) du signal d'excitation (ES) est réglé de sorte que les composantes I ($A_I$, $B_I$) du signal de mesure deviennent maximales.

11. Procédé selon l'une des revendications 1 à 10, **caractérisé en ce que** l'amplitude d'excitation (R0) est ajustée à une valeur de consigne d'amplitude prédéfinie.

12. Unité d'évaluation pour un capteur de position (1) inductif comportant une pièce en mouvement comportant un enroulement d'excitation (EW) et une pièce fixe comportant au moins un enroulement secondaire (SW), ou inversement, un signal d'excitation (ES) électrique comportant une fréquence d'excitation ($\omega$) et une amplitude d'excitation (R0) étant introduit dans l'enroulement d'excitation (EW), lequel signal d'excitation génère un champ d'excitation électromagnétique qui induit un signal de mesure (MS) dans l'enroulement secondaire (SW), lequel signal de mesure est amené à l'unité d'évaluation (2), et un signal de bruit (RS) étant superposé au signal de mesure (MS), et l'unité d'évaluation (2) déterminant une position (P) de la pièce en mouvement par rapport à la pièce fixe du capteur de position (1) à partir du signal de mesure (MS), **caractérisée en ce que** l'unité d'évaluation (2) est configurée pour former une fonction de fréquence ($F_f$) dépendant de la fréquence d'excitation ($\omega$) à partir du signal de mesure (MS), laquelle fonction de fréquence représente une mesure pour le signal de bruit (RS), **et en ce que** l'unité d'évaluation (2) est configurée pour déterminer la fréquence d'excitation ($\omega$) du signal d'excitation qui minimise ou maximise la fonction de fréquence ($F_f$) et la fréquence d'excitation ($\omega$) qui minimise ou maximise la fonction de fréquence ($F_f$) est utilisée pour le signal d'excitation (ES) lors de l'utilisation de l'unité d'évaluation (2).

Fig. 1

Fig. 2

Fig. 3

Fig. 4

## Fig. 5

## Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 602004005672 T2
- DE 102007011064 A1

- EP 1158276 A1

**In der Beschreibung aufgeführte Nicht-Patentliteratur**

- **GUO M. et al.** Noise Reduction for High-Accuracy Automatic Calibration of Resolver Signals via DVVT SVD Based Filter. *Electronics,* 2019, vol. 8 (5), 516